# EUROPEAN PATENT APPLICATION

(11) **EP 4 530 721 A1**
(43) Date of publication of application: **02.04.2025**
(21) Application number: 24202169.9
(22) Date of filing: 24.09.2024
(51) Int. Cl.: G03F 7/075, G03F 7/038, G03F 7/32, G03F 7/027

(54) **PHOTOSENSITIVE RESIN COMPOSITION AND PATTERN FORMING PROCESS**

(30) Priority: 25.09.2023 JP 2023161488
(71) Applicant: Shin-Etsu Chemical Co., Ltd., Tokyo 100-0005 (JP)
(72) Inventor: Maruyama, Hitoshi, Annaka-shi 3790224 (JP); Omori, Hiroto, Annaka-shi 3790224 (JP)
(74) Representative: Ter Meer Steinmeister & Partner

(57) **Abstract**

A photosensitive resin composition includes: (A) a silicone resin that has a silphenylene structure, a polysiloxane structure, and a fluorene structure at a main chain and has an acryloyl group or a methacryloyl group at a side chain; and (B) a photoradical generator.

## Description

### TECHNICAL FIELD

This invention relates to a photosensitive resin composition and a pattern forming process.

### BACKGROUND ART

In the prior art, photosensitive protective films for semiconductor devices and photosensitive insulating films for multilayer printed circuit boards are formed of photosensitive polyimide compositions, photosensitive epoxy resin compositions, photosensitive silicone compositions, and the like. As the photosensitive material applied for the protection of such substrates and circuits, Patent Document 1 discloses a photosensitive silicone composition having flexibility based on a silphenylene structure-containing silicone polymer.

A cured film obtained from the composition has high chemical resistance, copper migration resistance, and reliability. Meanwhile, as a post-exposure baking step (PEB step) is necessary because crosslinking does not progress unless the PEB step is performed during formation of a pattern, an acid as a catalyst is thermally diffused up to an unexposed region and micro-patterning has been difficult. In addition, recently, in order to reduce a thermal load on a device side, cold curing at 150°C or lower has been required in many cases. When the composition is post-cured at 150°C or higher after development, high chemical resistance, copper migration resistance, or the like is obtained, but when the composition is post-cured at 150°C or lower, there is a problem in that chemical resistance, copper migration resistance, or the like significantly deteriorates.

### Citation List

Patent Document 1: JP-A 2023-001980

### SUMMARY OF THE INVENTION

An object of the invention is to provide a photosensitive resin composition in which a fine size pattern is formed and a cured film has high chemical resistance or copper migration resistance even when cold-cured at 150°C or lower, and a pattern forming process thereof.

The inventors have found that the above-described object can be achieved by a photosensitive resin composition comprising a silicone resin that has a silphenylene structure, a polysiloxane structure, and a fluorene structure at a main chain and an acryloyl group or a methacryloyl group at a side chain, and a photoradical generator.

Accordingly, the invention provides a photosensitive resin composition and a pattern forming process, as defined below.
1. A photosensitive resin composition comprising:
   (A) a silicone resin that contains a silphenylene structure, a polysiloxane structure, and a fluorene structure at a main chain and an acryloyl group or a methacryloyl group at a side chain; and
   (B) a photoradical generator.
2. The photosensitive resin composition according to 1, wherein (A) the silicone resin is a polymer which contains a repeat unit of the formula (A1) and a repeat unit of the formula (A2) and may further contain at least one type selected from a repeat unit of the formula (A3) and a repeat unit of the formula (A4): 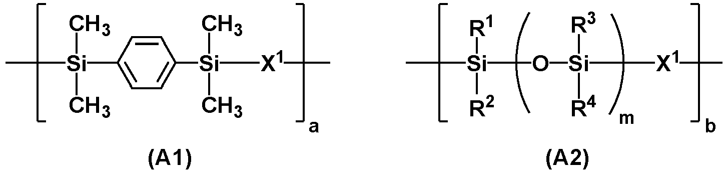 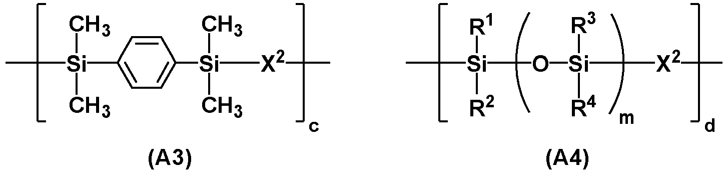
   wherein R¹ to R⁴ are each independently a C₁-C₂₀ hydrocarbyl group which may contain a heteroatom, m are each independently an integer of 1 to 600, groups R³ may be the same or different and groups R⁴ may be the same or different if m is an integer of at least 2, a, b, c, and d are numbers in the range: 0 < a < 1, 0 < b < 1, 0 ≤ c < 1, 0 ≤ d < 1, and a+b+c+d = 1, X¹ is a divalent group having the formula (X1), and X² is a divalent group having the formula (X2), 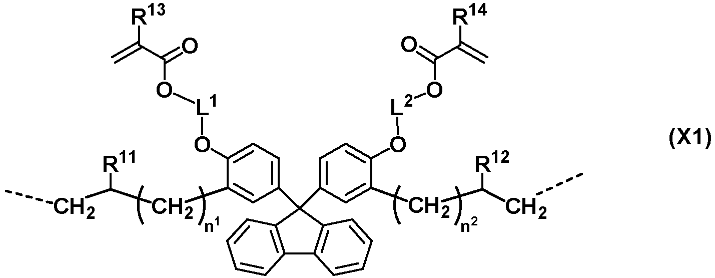
   wherein R¹¹ to R¹⁴ are each independently a hydrogen atom or a methyl group, n¹ and n² are each independently an integer of 1 to 7, L¹ and L² are each independently a C₁-C₁₅ saturated hydrocarbylene group, some of -CH₂- in the saturated hydrocarbylene group may be substituted by -O-, -S-, -SO₂-, -CO-, or -CONH-, and some or all of hydrogen atoms in the saturated hydrocarbylene group may be substituted by a hydroxy group, and a broken line is a valence bond, 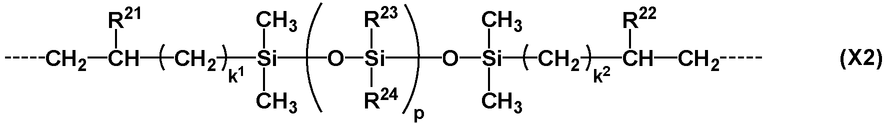
   wherein R²¹ and R²² are each independently a hydrogen atom or a methyl group, R²³ and R²⁴ are each independently a C₁-C₈ hydrocarbyl group, k¹ and k² are each independently an integer of 0 to 7, p is an integer of 0 to 600, and a broken line is a valence bond.
3. The photosensitive resin composition according to 1 or 2, further comprising (C) a crosslinker containing two or more (meth)acryloyl groups.
4. The photosensitive resin composition according to any one of 1 to 3, further comprising (D) a silane coupling agent.
5. The photosensitive resin composition according to any one of 1 to 4, further comprising (E) a solvent.
6. A pattern forming process comprising the steps of:
   (i) forming a photosensitive resin coating on a substrate using the photosensitive resin composition according to any one of 1 to 5;
   (ii) exposing the photosensitive resin coating to radiation; and
   (iii) developing the exposed photosensitive resin coating in a nonaqueous developer and dissolving an unexposed region to form a pattern.
7. The pattern forming process according to 6, further comprising (iv) a step of post-curing, at a temperature of 40 to 150°C, the photosensitive resin coating on which the pattern is formed by development.
8. The photosensitive resin composition according to any one of 1 to 5, which is a material of a coating for protection of electrical or electronic parts.

### ADVANTAGEOUS EFFECTS OF INVENTION

In the photosensitive resin composition according to the invention, unlike the photosensitive resin composition in the prior art including a silicone resin containing an epoxy group or a phenol group at a side chain and a photoacid generator, a fine size pattern can be formed, and a cured film having high chemical resistance or copper migration resistance can be formed even by cold-curing at 150°C or lower. In addition, since the cured film has the above-described characteristics, the photosensitive resin composition can be suitably used as a coating forming material for protection of various electrical or electronic parts such as circuit boards, semiconductor devices, or display devices.

### DESCRIPTION OF PREFERRED EMBODIMENTS

### Photosensitive resin composition

One embodiment of the invention is a photosensitive resin composition comprising: a (A) silicone resin that contains a silphenylene structure, a polysiloxane structure, and a fluorene structure at a main chain and an acryloyl group or a methacryloyl group at a side chain; and a (B) photoradical generator.

### (A) Silicone resin

(A) The silicone resin is a polymer that contains a silphenylene structure, a polysiloxane structure, and a fluorene structure at a main chain and an acryloyl group or a methacryloyl group at a side chain. The silicone resin is not particularly limited and is preferably a polymer which contains a repeat unit of the formula (A1) and a repeat unit of the formula (A2) and may further contain at least one type selected from a repeat unit of the formula (A3) and a repeat unit of the formula (A4).

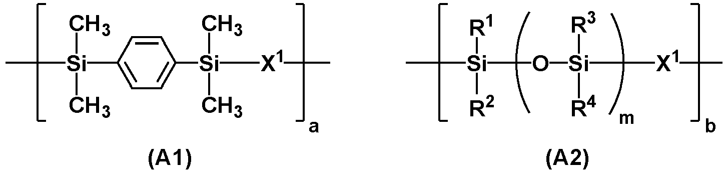

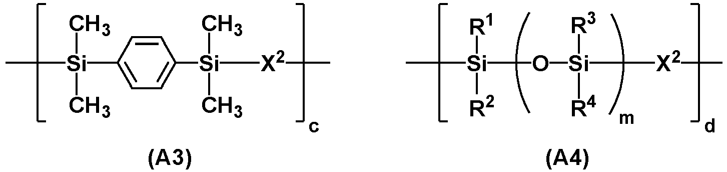

In the formulae (A1) to (A4), a, b, c, and d are numbers in the range: 0 < a < 1, 0 < b < 1, 0 ≤ c < 1, 0 ≤ d < 1, and a+b+c+d = 1, are preferably numbers in the range: 0.1 < a < 0.8, 0.1 < b < 0.8, 0 ≤ c < 0.3, 0 ≤ d < 0.3, and a+b+c+d = 1, and are more preferably numbers in the range: 0.35 < a < 0.75, 0.35 < b < 0.75, 0 ≤ c < 0.15, 0 ≤ d < 0.15,and a+b+c+d = 1.

In the formulae (A2) and (A4), R¹ to R⁴ are each independently a C₁-C₂₀ hydrocarbyl group which may contain a heteroatom. m are each independently an integer of 1 to 600 and preferably an integer of 8 to 100. Groups R³ may be the same or different and groups R⁴ may be the same or different if m is an integer of at least 2.

When two or more siloxane units are included in the formulae (A2) and (A4) (that is, when m is an integer of at least 2), all the siloxane units may be the same or siloxane units of two or more different types may be included. When two or more different siloxane units are included, the siloxane units may be bonded randomly or alternately, or a plurality of blocks of siloxane units of the same type may be included.

In the formulae (A1) and (A2), X¹ is a divalent group having the formula (X1). The divalent group of the formula (X1) is a group containing a fluorene structure: 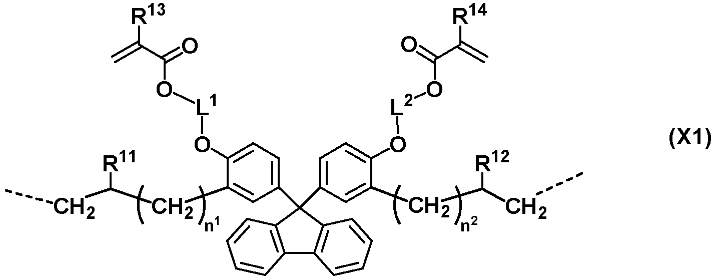 wherein a broken line is a valence bond.

In the formula (X1), R¹¹ to R¹⁴ are each independently a hydrogen atom or a methyl group, and preferably, both R¹¹ and R¹² are a hydrogen atom.

In the formula (X1), n¹ and n² are each independently an integer of 1 to 7 and preferably 1.

In the formula (X1), L¹ and L² are each independently a C₁-C₁₅ saturated hydrocarbylene group, some of -CH₂- in the saturated hydrocarbylene group may be substituted by -O-, -S-, -SO₂-, -CO-, -CONH-, and some or all of hydrogen atoms in the saturated hydrocarbylene group may be substituted by a hydroxy group. -CH₂- in the saturated hydrocarbylene group may be positioned at a terminal thereof.

The saturated hydrocarbylene group may be linear, branched, or cyclic, and specific examples thereof include: a C₁-C₁₅ alkanediyl group such as a methanediyl group, an ethane-1,1-diyl group, an ethane-1,2-diyl group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, a dodecane-1,12-diyl group, a tridecane-1,13-diyl group, a tetradecane-1,14-diyl group, or a pentadecane-1,15-diyl group; and a C₃-C₁₅ cyclic saturated hydrocarbylene group such as a cyclopentanediyl group, a cyclohexanediyl group, a norbornanediyl group, or an adamantanediyl group.

It is preferable that both L¹ and L² contain 1 to 8 carbon atoms, and it is more preferable that one or more hydrogen atoms are substituted by a hydroxy group or one or more -CH₂- are substituted by -CONH-.

In the formulae (A3) and (A4), X² is a divalent group having the formula (X2): 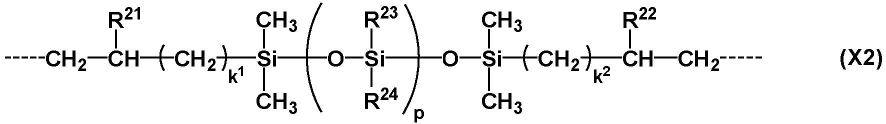 wherein a broken line is a valence bond.

In the formula (X2), R²¹ and R²² are each independently a hydrogen atom or a methyl group and preferably a hydrogen atom.

In the formula (X2), R²³ and R²⁴ are each independently a C₁-C₈ hydrocarbyl group.

In the formula (X2), k¹ and k² are each independently an integer of 0 to 7 and preferably 0.

In the formula (X2), p is an integer of 0 to 600, preferably an integer of 0 to 100, and more preferably an integer of 0 to 30. Groups R²³ may be the same or different and groups R²⁴ may be the same or different if p is an integer of at least 2.

A weight average molecular weight (Mw) of (A) the silicone resin is preferably 2,000 to 500,000 and more preferably 4,000 to 100,000. If Mw is in the range, a solid polymer can be obtained, and film formability can also be secured. It is noted that, in the invention, Mw is a value measured by gel permeation chromatography (GPC) in terms of polystyrene using tetrahydrofuran (THF) as an eluting solvent.

In (A) the silicone resin, the repeat unit having the formula (A1), the repeat unit having the formula (A2), the repeat unit having the formula (A3), and the repeat unit having the formula (A4) may be bonded randomly or alternately, or a plurality of blocks of each unit may be contained.

### Method of manufacturing (A) silicone resin

A method of manufacturing (A) the silicone resin is not particularly limited and, for example, can be manufactured by addition polymerization of a compound of the formula (1), a compound of the formula (2), and a compound of the formula (3) and, if necessary, a compound of the formula (4), while using a metal catalyst: 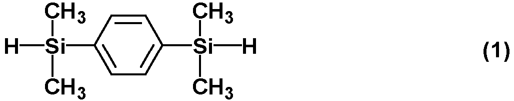 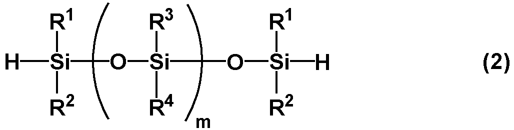
wherein R¹ to R⁴ and m are as described above, 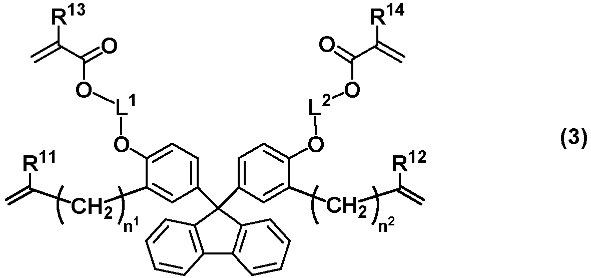
wherein R¹¹ to R¹⁴, n¹, n², L¹, and L² are as described above, and 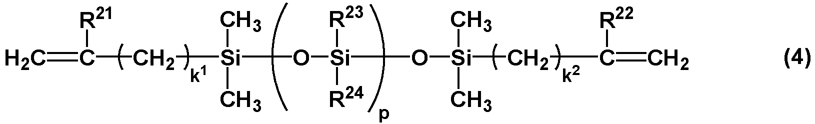
wherein R²¹ to R²⁴, k¹, k², and p are as described above.

Examples of the metal catalyst that can be used include: an alone platinum group metal such as platinum (including platinum black), rhodium, or palladium; platinum chloride, chloroplatinic acid, or a chloroplatinate such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂, or Na₂HPtCl₄·xH₂O (wherein x is preferably an integer from 0 to 6 and more preferably 0 or 6); an alcohol-modified chloroplatinic acid (for example, those described in US 3,220,972); a complex of chloroplatinic acid and olefin (for example, those described in US 3,159,601, US 3,159,662 and US 3,775,452); a support such as alumina, silica, or carbon on which a platinum group metal such as platinum black or palladium is supported; a rhodium-olefin complex; chlorotris(triphenylphosphine)rhodium (so-called Wilkinson catalyst); and a complex of platinum chloride or chloroplatinic acid, a chloroplatinate, and a vinyl group-containing siloxane (in particular, a vinyl group-containing cyclic siloxane).

An amount of catalyst to be used is a catalyst quantity and, typically, is preferably 0.001 to 0.1 wt% per total amount of reactants as the platinum group metal. In a polymerization reaction, a solvent may be used as necessary. As the solvent, for example, a hydrocarbon solvent such as toluene or xylene is preferable. As a polymerization condition, from the viewpoint of completing polymerization within a short period of time without deactivation of the catalyst, the polymerization temperature is, for example, preferably 40 to 150°C and more preferably 60 to 120°C. A polymerization time varies depending on the type and amount of the polymer and is preferably about 0.5 to 100 hours and more preferably 0.5 to 30 hours to prevent penetration of moisture into a polymerization system. When the solvent is used, the solvent is distilled off after completion of the polymerization reaction, and as a result, (A) the silicone resin can be obtained.

The reaction method is not particularly limited, and after mixing and heating the compound having the formula (3) and the compound having the formula (4), the metal catalyst may be added to the mixed solution, and subsequently the compound having the formula (1) and the compound having the formula (2) may be added dropwise over 0.1 to 5 hours.

The raw material compounds are compounded such that a molar ratio of the total amount of hydrosilyl groups in the compound having the formula (1) and the compound having the formula (2) to the total amount of alkenyl groups in the compound having the formula (3) and the compound having the formula (4) is preferably 0.67 to 1.67 and more preferably 0.83 to 1.25. Mw of (A) the silicone resin can be controlled by using a monoallyl compound such as o-allylphenol or a monohydrosilane or monohydrosiloxane such as triethylhydrosilane as a molecular weight modifier.

In the polymerization reaction, a polymerization inhibitor may be used. As the polymerization inhibitor, various phenols, hydroquinones, benzoquinones, catechols, hydroxyamines, nitroso compounds, or the like can be used. The amount of the polymerization inhibitor to be used is not particularly limited and is preferably 0.001 wt% to 10 wt% and more preferably 0.01 to 5 wt% per the compound having the formula (3).

The solvent may be added after completion of the reaction and the organic layer is heated under reduced pressure after washing with water to distill off the solvent, thereby obtaining (A) the silicone resin. In addition, while washing with water, an aqueous solution of a metal hydroxide such as sodium hydroxide or potassium hydroxide or a metal carbonate or a metal hydrogencarbonate such as sodium carbonate, sodium hydrogencarbonate, or potassium carbonate may be used.

Examples of another manufacturing method of (A) the silicone resin include a reaction of a polymer (hereinafter, also referred to as a polymer B) which contains a repeat unit having the formula (B 1) and a repeat unit having the formula (B2) and may further contain at least one type selected from a repeat unit having the formula (B3) and a repeat unit having the formula (B4) with a compound having the formula (5): 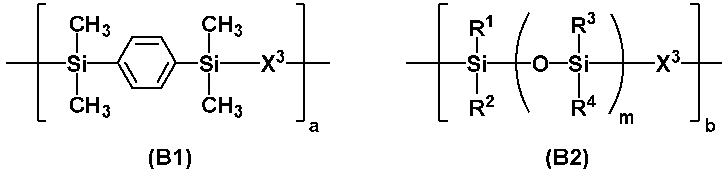 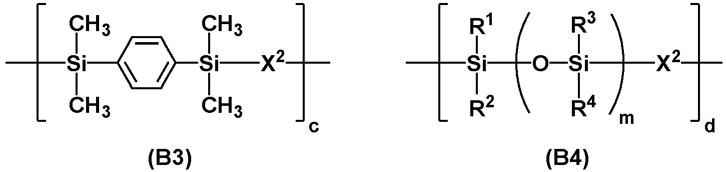 wherein R¹ to R⁴, m, a, b, c, d, and X² are as described above.

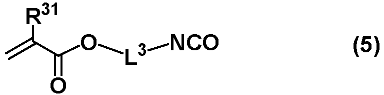

In the formulae (B1) and (B2), X³ is a divalent group having the formula (X3). The divalent group having the formula (X3) is a group having a fluorene structure: 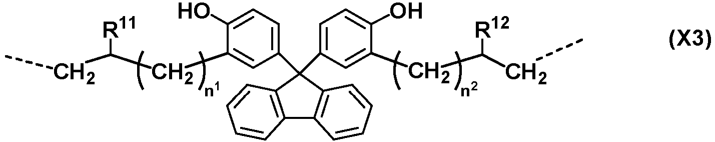 wherein R¹¹, R¹², n¹, and n² are as described above, and a broken line is a valence bond.

In the formula (5), R³¹ is a hydrogen atom or a methyl group.

In the formula (5), L³ is a C₁-C₁₄ saturated hydrocarbylene group, some of -CH₂- in the saturated hydrocarbylene group may be substituted by -O-, -S-, -SO₂-, -CO-, -CONH-, and some or all of hydrogen atoms in the saturated hydrocarbylene group may be substituted by a hydroxy group. The saturated hydrocarbylene group of L³ may be linear, branched, or cyclic and has preferably 1 to 7 carbon atoms.

Specific examples of the compound having the formula (5) include 2-acryloyloxyethyl isocyanate (Karenz AOI^{®} manufactured by Showa Denko K.K.), 2-methacryloyloxyethyl isocyanate (Karenz MOI^{®} manufactured by Showa Denko K.K.), and 2-(2-methacryloyloxyethyloxy)ethyl isocyanate (Karenz MOI-EG^{®} manufactured by Showa Denko K.K.), and the compound having the formula (5) is not limited thereto.

Reaction conditions are not particularly limited, and typically, the polymer B and the compound having the formula (5) may be mixed in a solvent and heated. From the viewpoint of accelerating the reaction and suppressing a side reaction, as the solvent, an aprotic polar solvent is preferably used, and ketones such as cyclopentanone or cyclohexanone, cyclic ethers such as tetrahydrofuran or 1,4-dioxane, or esters such as ethyl acetate or propylene glycol monomethyl ether acetate are more preferably used. From the viewpoint of preventing a side reaction and completing the reaction within a short period of time, the reaction temperature is, for example, preferably 35 to 130°C and more preferably 45 to 100°C. The reaction time varies depending on the type and amount of the reactant and is preferably about 0.5 to 50 hours and more preferably 0.5 to 24 hours.

Regarding a compounding ratio between the polymer B and the compound having the formula (5) in the reaction, the compound having the formula (5) is compounded such that a molar ratio thereof to X³ in the polymer B is preferably 1.80 to 2.20 and more preferably 1.95 to 2.10. The compound having the formula (5) may be used alone or in combination of two or more types.

In the reaction, a catalyst may be used. Examples of the catalyst include: amines such as triethylamine, triethylenediamine, bis-(2-dimethylaminoethyl)ether, or N-methylmorpholine; phosphines such as triphenylphosphine or tri(o-tolyl)phosphine; quaternary ammonium salts such as tetrabutylammonium chloride, benzyltriethylammonium chloride, or tetraethylhydroxylammonium; imidazoles such as imidazole or 2-ethyl-4-methylimidazole; pyridines such as pyridine, N,N-dimethyl-4-aminopyridine, or 2,6-lutidine; organotin compounds such as tin acetate, tin octylate, tin oleate, tin laurate, dibutyltin diacetate, dimethyltin dilaurate, dibutyltin dilaurate, dibutyltin dimercaptide, dibutyltin maleate, dibutyltin dilaurate (dibutyltin(IV) dilaurate), dibutyltin dineodecanoate, dioctyltin dimercaptide, dioctyltin dilaurate, or dibutyltin dichloride; organolead compounds such as lead octanoate or lead naphthenate; organonickel compound such as nickel naphthenate; organocobalt compounds such as cobalt naphthenate; organocopper compounds such as copper octenate; organobismuth compounds such as bismuth octylate or bismuth neodecanoate; and potassium salts such as potassium carbonate, potassium acetate, or potassium octylate.

The amount of the catalyst to be used is typically the catalyst quantity and is preferably 0.1 to 20 mol% per X³ in the polymer B. The catalyst may be used alone or in combination of two or more types.

In the reaction, a polymerization inhibitor may be used. As the polymerization inhibitor, various phenols, hydroquinones, benzoquinones, catechols, hydroxyamines, nitroso compounds, or the like can be used. The amount of the polymerization inhibitor to be used is not particularly limited and is preferably 0.001 to 10 wt% and more preferably 0.01 to 5 wt% per the compound having the formula (3).

The solvent may be added after completion of the reaction and the organic layer is heated under reduced pressure after washing with water to distill off the solvent, thereby obtaining (A) the silicone resin. In addition, while washing with water, an aqueous solution of a metal hydroxide such as sodium hydroxide or potassium hydroxide or a metal carbonate or a metal hydrogencarbonate such as sodium carbonate, sodium hydrogencarbonate, or potassium carbonate may be used.

Further, examples of the another manufacturing method of (A) the silicone resin include a reaction of the polymer B and the compound having the formula (6).

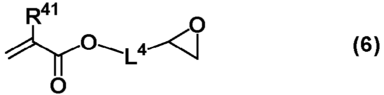

In the formula (6), R⁴¹ is a hydrogen atom or a methyl group.

In the formula (6), L⁴ is a C₁-C₁₃ divalent saturated hydrocarbylene group, some of -CH₂- in the saturated hydrocarbylene group may be substituted by -O-, -S-, -SO₂-, -CO-, -CONH-, and some or all of hydrogen atoms in the saturated hydrocarbylene group may be substituted by a hydroxy group. The saturated hydrocarbylene group of L³ may be linear, branched, or cyclic and has preferably 1 to 6 carbon atoms.

Reaction conditions are not particularly limited, and typically, the polymer B and the compound having the formula (6) may be mixed in a solvent and heated. From the viewpoint of accelerating the reaction and suppressing a side reaction, as the solvent, an aprotic polar solvent is preferably used, and ketones such as cyclopentanone or cyclohexanone, cyclic ethers such as tetrahydrofuran or 1,4-dioxane, or esters such as ethyl acetate or propylene glycol monomethyl ether acetate are more preferably used. From the viewpoint of preventing a side reaction and completing the reaction within a short period of time, the reaction temperature is, for example, preferably 35 to 130°C and more preferably 45 to 100°C. The reaction time varies depending on the type and amount of the reactant and is preferably about 0.5 to 50 hours and more preferably 0.5 to 24 hours.

Regarding a compounding ratio between the polymer B and the compound having the formula (6) in the reaction, the compound having the formula (6) is compounded such that a molar ratio thereof to X³ in the polymer B is preferably 1.60 to 3.00 and more preferably 1.90 to 2.00. The compound having the formula (6) may be used alone or in combination of two or more types.

In the reaction, a catalyst may be used. Examples of the catalyst include: amines such as triethylamine, triethylenediamine, bis-(2-dimethylaminoethyl)ether, or N-methylmorpholine; phosphines such as triphenylphosphine or tri(o-tolyl)phosphine; quaternary ammonium salts such as tetrabutylammonium chloride, benzyltriethylammonium chloride, or tetraethylhydroxylammonium; imidazoles such as imidazole or 2-ethyl-4-methylimidazole; potassium salts such as potassium hydroxide, potassium carbonate, potassium acetate, or potassium octylate; and sodium salts such as sodium hydroxide, sodium carbonate, sodium acetate, or sodium octylate.

The amount of the catalyst to be used is typically the catalyst quantity and is preferably 0.1 to 20 mol% per X³ in the polymer B. The catalyst may be used alone or in combination of two or more types.

In the reaction, a polymerization inhibitor may be used. As the polymerization inhibitor, various phenols, hydroquinones, benzoquinones, catechols, hydroxyamines, nitroso compounds, or the like can be used. The amount of the polymerization inhibitor to be used is not particularly limited and is preferably 0.001 to 10 wt% and more preferably 0.01 to 5 wt% per the compound having the formula (6).

The solvent may be added after completion of the reaction and the organic layer is heated under reduced pressure after washing with water to distill off the solvent, thereby obtaining (A) the silicone resin. In addition, while washing with water, an aqueous solution of a metal hydroxide such as sodium hydroxide or potassium hydroxide or a metal carbonate or a metal hydrogencarbonate such as sodium carbonate, sodium hydrogencarbonate, or potassium carbonate may be used.

Examples of another manufacturing method of (A) the silicone resin include a reaction of a polymer (hereinafter, also referred to as a polymer C) which contains a repeat unit having the formula (C1) and a repeat unit having the formula (C2) and may further contain at least one selected from a repeat unit having the formula (C3) and a repeat unit having the formula (C4) with acrylic acid or methacrylic acid: 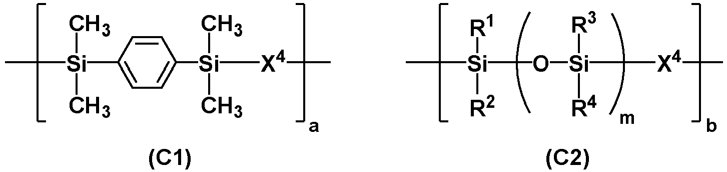 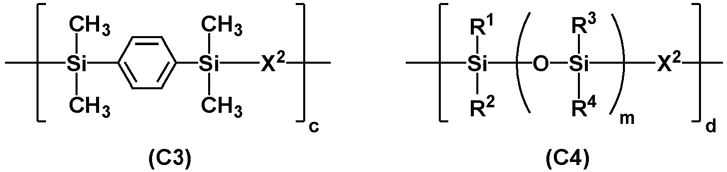 wherein R¹ to R⁴, m, a, b, c, d, and X² are as described above.

In the formulae (C1) and (C2), X⁴ is a divalent group having the formula (X4). The divalent group having the formula (X4) is a group having a fluorene structure: 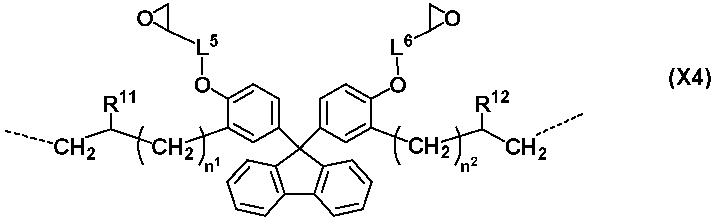 wherein R¹¹, R¹², n¹, and n² are as described above, and a broken line is a valence bond.

In the formula (X4), L⁵ and L⁶ are each independently a C₁-C₁₃ saturated hydrocarbylene group, some of -CH₂- in the saturated hydrocarbylene group may be substituted by -O-, -S-, -SO₂-, -CO-, -CONH-, and some or all of hydrogen atoms in the saturated hydrocarbylene group may be substituted by a hydroxy group. The saturated hydrocarbylene group of L⁵ and L⁶ may be linear, branched, or cyclic and has preferably 1 to 6 carbon atoms.

Reaction conditions are not particularly limited, and typically, the polymer C and the acrylic acid or the methacrylic acid may be mixed in a solvent and heated. From the viewpoint of accelerating the reaction, as the solvent, a polar solvent is preferably used, and an alcohol solvent such as propylene glycol monomethyl ether is more preferably used. From the viewpoint of preventing a side reaction and completing the reaction within a short period of time, the reaction temperature is, for example, preferably 35 to 130°C and more preferably 60 to 110°C. The reaction time varies depending on the type and amount of the reactant and is preferably about 0.5 to 50 hours and more preferably 0.5 to 24 hours.

Regarding a compounding ratio between the polymer C and the acrylic acid or the methacrylic acid in the reaction, the acrylic acid or the methacrylic acid is compounded such that a molar ratio thereof per X⁴ in the polymer C is preferably 2.00 to 10.00 and more preferably 3.00 to 8.00. Any one of the acrylic acid or the methacrylic acid may be used alone, or both of the acrylic acid and the methacrylic acid may be used in combination.

In the reaction, a catalyst may be used. Examples of the catalyst include: amines such as triethylamine, triethylenediamine, bis-(2-dimethylaminoethyl)ether, or N-methylmorpholine; phosphines such as triphenylphosphine or tri(o-tolyl)phosphine; quaternary ammonium salts such as tetrabutylammonium chloride, benzyltriethylammonium chloride, or tetraethylhydroxylammonium; and imidazoles such as imidazole or 2-ethyl-4-methylimidazole.

The amount of the catalyst to be used is typically the catalyst quantity and is preferably 0.1 to 20 mol% per X⁴ in the polymer C. The catalyst may be used alone or in combination of two or more types.

In the reaction, a polymerization inhibitor may be used. As the polymerization inhibitor, various phenols, hydroquinones, benzoquinones, catechols, hydroxyamines, nitroso compounds, or the like can be used. The amount of the polymerization inhibitor to be used is not particularly limited and is preferably 0.001 to 10 wt% and more preferably 0.01 to 5 wt% per the acrylic acid or the methacrylic acid.

The solvent may be added after completion of the reaction and the organic layer is heated under reduced pressure after washing with water to distill off the solvent, thereby obtaining (A) the silicone resin. In addition, while washing with water, an aqueous solution of a metal hydroxide such as sodium hydroxide or potassium hydroxide or a metal carbonate or a metal hydrogencarbonate such as sodium carbonate, sodium hydrogencarbonate, or potassium carbonate may be used.

### (B) Photoradical generator

The photoradical generator as a component (B) is not particularly limited as long as it is a compound that generates a radical by exposure, and specific examples thereof include an acetophenone compound, a benzophenone compound, a thioxanthone compound, a benzoin compound, a triazine compound, and an oxime compound.

Specific examples of the acetophenone compound include 2,2'-diethoxyacetophenone, 2,2'-dibutoxyacetophenone, 2-hydroxy-2-methylpropiophenone, p-t-butyltrichloroacetophenone, p-t-butyldichloroacetophenone, 4-chloroacetophenone, 2,2' -dichloro-4-phenoxy acetophenone, 2-methyl-1-(4-(methylthio)phenyl)-2-morpholinopropane-1-one, and 2-benzyl-2-dimethylamino-1 -(4-morpholinophenyl)-butane-1 -one.

Specific examples of the benzophenone compound include benzophenone, benzoylbenzoic acid, methyl benzoylbenzoate, 4-phenylbenzophenone, hydroxybenzophenone, acrylated benzophenone, 4,4'-bis(dimethylamino)benzophenone, 4,4'-bis(diethylamino)benzophenone, 4,4'-dimethylaminobenzophenone, 4,4'-dichlorobenzophenone, and 3,3'-dimethyl-2-methoxybenzophenone.

Specific examples of the thioxanthone compound include thioxanthone, 2-methylthioxanthone, isopropylthioxanthone, 2,4-diethylthioxanthone, 2,4-diisopropylthioxanthone, and 2-chlorothioxanthone.

Specific examples of the benzoin compound include benzoin, benzoin methyl ether, benzoin ethyl ether, benzoin isopropyl ether, benzoin isobutyl ether, and benzyl dimethyl ketal.

Specific examples of the triazine compound include 2,4,6-trichloro-s-triazine, 2-phenyl-4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, bis(trichloromethyl)-6-styryl-s-triazine, 2-(naphtho-1-yl)-4,6-bis(trichloromethyl)-s-triazine, 2-(4-methoxynaphtho-1-yl)-4,6-bis(trichloromethyl)-s-triazine, 2,4-bis(trichloromethyl)-6-piperonyl-s-triazine, and 2,4-bis(trichloromethyl)-6-(4-methoxystyryl)-s-triazine.

Specific examples of the oxime compound include 1,2-octanedione, an O-acyloxime compound, 2-(O-benzoyloxime)-1-[4-(phenylthio)phenyl]-1,2-octanedione, 1-(O-acetyloxime)-1-[9-ethyl-6-(2-methylbenzoyl)-9H-carbazol-3-yl]ethanone, and O-ethoxycarbonyl-α-oxyamino-1-phenylpropane-1-one. Specific examples of the O-acyloxime compound include 2-dimethylamino-2-(4-methylbenzyl)-1-(4-morpholine-4-yl-phenyl)-butane-1-one, 1-(4-phenylsulfanylphenyl)-butane-1,2-dione-2-oxime-O-benzoate, 1-(4-phenylsulfanylphenyl)-octane-1,2-dione-2-oxime-O-benzoate, 1-(4-phenylsulfanylphenyl)-octane-1-oneoxime-O-acetate, and 1 -(4-phenylsulfanylphenyl)-butane-1 -oneoxime-O-acetate.

Specific examples of the phosphine oxide compound include 2,4,6-trimethylbenzoyl-diphenyl-phosphine oxide and bis(2,4,6-trimethylbenzoyl)-phenylphosphine oxide.

As (B) the photoradical generator, in addition to the above-described compounds, a carbazole compound, a diketone compound, a sulfonium borate compound, a diazo compound, an imidazole compound, a non-imidazole compound, a fluorene compound, or the like can be used.

The content of (B) the photoradical generator in the photosensitive resin composition according to the invention is preferably 0.1 to 20 parts by weight and more preferably 0.5 to 10 parts by per 100 parts by weight of the component (A). If the content of the photoradical generator is in the range, a balance between sensitivity and developability during exposure is good, a pattern having a high resolution can be obtained without residues, and a cured film having high reliability can be obtained. (B) The photoradical generator may be used alone or in combination of two or more types.

### (C) Crosslinker

The photosensitive resin composition according to the invention may further contain a crosslinker as a component (C). (C) The crosslinker induces a crosslinking reaction with (A) the silicone resin and functions to facilitate formation of a pattern having a good shape, and a crosslinker having a di- or higher functional (meth)acryloyl group is preferable.

Specific examples of the crosslinker having a di- or higher functional (meth)acryloyl group include ethylene glycol di(meth)acrylate, diethylene glycol di(meth)acrylate, tetraethylene glycol di(meth)acrylate, propylene glycol di(meth)acrylate, polypropylene glycol di(meth)acrylate, butylene glycol di(meth)acrylate, neopentyl glycol di(meth)acrylate, 1,6-hexaneglycol di(meth)acrylate, trimethylolpropane tri(meth)acrylate, glycerin di(meth)acrylate, pentaerythritol triacrylate, pentaerythritol tetraacrylate, dipentaerythritol pentaacrylate, dipentaerythritol hexaacrylate, pentaerythritol di(meth)acrylate, pentaerythritol tri(meth)acrylate, pentaerythritol tetra(meth)acrylate, dipentaerythritol penta(meth)acrylate, dipentaerythritol hexa(meth)acrylate, 2,2-bis(4-(meth)acryloxydiethoxyphenyl)propane, 2,2-bis(4-(meth)acryloxypolyethoxyphenyl)propane, 2-hydroxy-3-(meth)acryloyloxypropyl(meth)acrylate, ethylene glycol diglycidyl ether di(meth)acrylate, diethylene glycol diglycidyl ether di(meth)acrylate, diglycidyl phthalate di(meth)acrylate, glycerin triacrylate, glycerin polyglycidyl ether poly(meth)acrylate, urethane (meth)acrylate (that is, a reactant of tolylene diisocyanate, trimethylhexamethylene diisocyanate, hexamethylene diisocyanate, or the like and 2-hydroxyethyl (meth)acrylate), methylene bis(meth)acrylamide, (meth)acrylamide methylene ether, a polyfunctional monomer such as a condensate of polyhydric alcohol and N-methylol (meth)acrylamide, and triacrylformal.

When the photosensitive resin composition according to the invention contains (C) the crosslinker, the content thereof is preferably 0.5 to 100 parts by weight and more preferably 1 to 50 parts by weight per 100 parts by weight of the component (A). (C) The crosslinker may be used alone or in combination of two or more types.

### (D) Silane coupling agent

In order to improve adhesion with the substrate, the photosensitive resin composition according to the invention may further contain a silane coupling agent as a component (D).

Examples of (D) the silane coupling agent include an amino group-containing silane coupling agent, an epoxy group-containing silane coupling agent, a (meth)acryloyl group-containing silane coupling agent, a mercapto group-containing silane coupling agent, a vinyl group-containing silane coupling agent, an ureido group-containing silane coupling agent, a styryl group-containing silane coupling agent, and a silane coupling agent having a cyclic anhydride structure, and among these, a (meth)acryloyl group-containing silane coupling agent is preferable.

Specific examples of the amino group-containing silane coupling agent include KBM-602, KBM-603, KBM-903, and KBM-573 (manufactured by Shin-Etsu Chemical Co., Ltd.). Specific examples of the epoxy group-containing silane coupling agent include KBM-303, KBM-402, KBM-403, and KBE-402 (manufactured by Shin-Etsu Chemical Co., Ltd.). Specific examples of the (meth)acryloyl group-containing silane coupling agent include KBM-502, KBM-503, KBE-502, KBE-503, and KBM-5103 (manufactured by Shin-Etsu Chemical Co., Ltd.). Specific examples of the mercapto group-containing silane coupling agent include KBM-802 and KBM-803 (manufactured by Shin-Etsu Chemical Co., Ltd.). Specific examples of the vinyl group-containing silane coupling agent include KBM-1003 and KBE-1003 (manufactured by Shin-Etsu Chemical Co., Ltd.). Specific examples of the ureido group-containing silane coupling agent include KBE-585A (manufactured by Shin-Etsu Chemical Co., Ltd.). Specific examples of the styryl group-containing silane coupling agent include KBM-1403 (manufactured by Shin-Etsu Chemical Co., Ltd.). Specific examples of the silane coupling agent having a cyclic anhydride structure include X-12-967C (manufactured by Shin-Etsu Chemical Co., Ltd.).

When the photosensitive resin composition according to the invention contains (D) the silane coupling agent, the content thereof is preferably 0.5 to 20 parts by weight and more preferably 1 to 10 parts by weight per 100 parts by weight of the component (A). (D) The silane coupling agent may be used alone or in combination of two or more types.

### (E) Solvent

The photosensitive resin composition according to the invention may further contain a solvent as a component (E). (E) The solvent is not particularly limited as long as the components (A) to (D) described above and other additives are soluble and dispersible therein.

As (E) the solvent, an organic solvent is preferable, and examples thereof include: ketones such as cyclohexanone, cyclopentanone, or methyl-2-n-pentylketone; alcohols such as 3-methoxybutanol, 3-methyl-3-methoxybutanol, 1-methoxy-2-propanol, or 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, or diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate, or γ-butyrolactone.

As (E) the solvent, propylene glycol monomethyl ether acetate, propylene glycol monomethyl ether, cyclopentanone, or a mixed solvent thereof having excellent solubility of (A) the silicone resin or (B) the photoradical generator is preferable.

From the viewpoints of compatibility and viscosity of the photosensitive resin composition, the content of the component (E) is preferably 25 to 85 wt% and more preferably 30 to 80 wt% per the total amount of the photosensitive resin composition. (E) The solvent may be used alone or as a mixture of two or more types.

The photosensitive resin composition according to the invention is prepared using a typical method. For example, by mixing and stirring each of the components and, if necessary, filtering solids through a filter or the like, the photosensitive resin composition according to the invention can be prepared.

The photosensitive resin composition according to the invention prepared as described above can be suitably used as a coating forming material for protection of various electrical or electronic parts such as circuit boards, semiconductor devices, or display devices.

### Pattern forming process

A pattern forming process using the photosensitive resin composition according to the invention, the process comprising the steps of:
(i) forming a photosensitive resin coating on a substrate using the photosensitive resin composition according to the invention;
(ii) exposing the photosensitive resin coating to radiation; and
(iii) developing the exposed photosensitive resin coating in a developer to form a pattern.

In the step (i), a photosensitive resin coating is formed on a substrate using the photosensitive resin composition. Examples of the substrate include a silicon wafer, a silicon wafer for a through-electrode, a silicon wafer thinned by back grinding, a plastic or ceramic substrate, and a substrate where a partial surface or the entire surface contains metal such as Ni or Au by an ion sputtering method, a plating method, or the like. In addition, a substrate having unevenness may be used.

Examples of a method of forming the photosensitive resin coating include a method of coating the substrate with the photosensitive resin composition and, if necessary, prebaking the photosensitive resin composition. The coating method may be a well-known method, and examples thereof include dipping, spin coating, and roll coating. The coating amount of the photosensitive resin composition can be appropriately selected according to the purpose, and a thickness of the obtained photosensitive resin coating is preferably 0.1 to 200 µm and more preferably 1 to 150 µm.

In order to improve thickness uniformity on the substrate surface, a solvent may be added dropwise to the substrate before coating the photosensitive resin composition (pre-wetting method). The solvent to be added dropwise and the amount thereof can be appropriately selected according to the purpose. As the solvent, for example, alcohols such as isopropyl alcohol (IPA), ketones such as cyclohexanone, or glycols such as PGME are preferable, and the solvents used for the photosensitive resin composition can also be used.

Here, in order to efficiently perform a photocuring reaction, if necessary, prebaking may be performed to volatilize the solvent and the like in advance. Prebaking can be performed, for example, at 40 to 140°C for about 1 minute to 1 hour.

Next, (ii) the photosensitive resin coating is exposed to radiation. Here, the exposure is performed using preferably light having a wavelength of 10 to 600 nm and more preferably light having a wavelength of 190 to 500 nm. Examples of the light having such wavelength include light rays having various wavelengths emitted from a radiation generator, for example, an ultraviolet ray such as a g-ray, a h-ray, or an i-ray and a far ultraviolet ray (248 nm, 193 nm). Among these, light having a wavelength of 248 to 436 nm is particularly preferable. The exposure amount is preferably 10 to 10,000 mJ/cm². In the invention, a crosslinking reaction progresses in the exposed region without performing the PEB step, and an insolubilized pattern that is insoluble in the organic solvent as the developer is formed. Since the PEB step is not performed, the catalyst species generated in the exposed region can be prevented from being thermally diffused up to the unexposed region, and micro-patterning can be achieved.

The exposure may be performed through a photomask. The photomask may be, for example, perforated with a desired pattern. Although the material of the photomask is not particularly limited, a material that shields the light having the described wavelength is preferable, and for example, a material including chromium as a shielding film is suitably used.

After exposure, (iii) the photosensitive resin coating is developed with a developer to form a pattern. As the developer, for example, organic solvents including alcohols such as IPA, ketones such as cyclohexanone, or glycols such as PGME are preferable, and the solvents used for the photosensitive resin composition can also be used. Examples of the development method include a typical method, for example, a method of dipping the substrate on which the pattern is formed in the developer. The unexposed region is dissolved away by the development using the organic solvent and a pattern is formed. Then, washing, rinsing, drying, or the like is performed as necessary, and a resin coating having a desired pattern is obtained.

Further, (iv) the coating on which the pattern is formed can be post-cured using an oven or a hot plate at a low temperature of 40 to 140°C. If the post-curing temperature is 40 to 140°C, the stacked semiconductor device is not damaged, the crosslinking density of the photosensitive resin composition is increased, and high chemical resistance, copper migration resistance, or reliability of the cured film can be secured. The post-curing time is preferably 10 minutes to 12 hours and more preferably 1 hour to 6 hours. By using the photosensitive resin composition according to the invention, even when post-curing is performed at a low temperature of about 40 to 140°C, a coating having excellent various cured film characteristics can be obtained. The thickness of the post-cured film is typically 1 to 200 µm and preferably 5 to 50 µm.

When it is not necessary to form a pattern, for example, when formation of a simple uniform coating is desired, the coating may be formed by performing the exposure using light having an appropriate wavelength without passing through the photomask in the step (ii) of the pattern forming process.

In the coating obtained from the photosensitive resin composition, high chemical resistance, copper migration resistance, or reliability of the cured film can be secured even when cold-curing is performed. For example, the photosensitive resin composition can be suitably used as a coating forming material for protection of various electrical or electronic parts such as circuit boards, semiconductor devices, or display devices.

### EXAMPLES

Hereinafter, the invention is described in more detail using Synthesis Examples, Examples, and Comparative Examples, and the invention is not limited to Examples. Mw was measured by GPC in terms of monodisperse polystyrene using TSKgel Super HZM-H (manufactured by Tosoh Corporation) as a column under analytical conditions of a flow rate of 0.6 mL/min, an eluting solvent of THF, and a column temperature of 40°C.

Compounds used for synthesis of polymers were as follows.

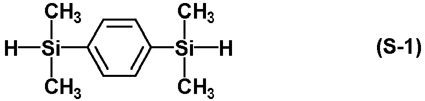

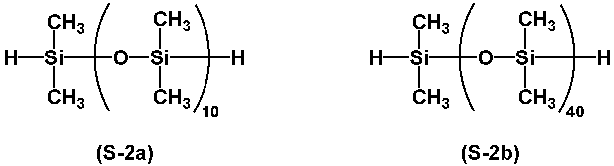

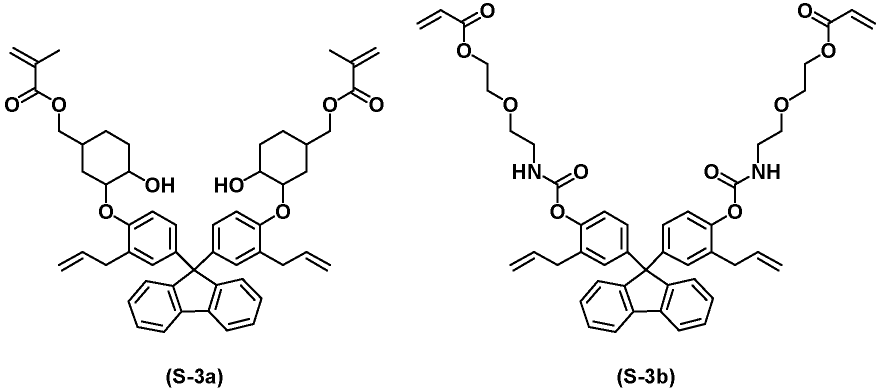

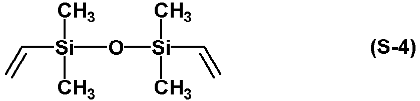

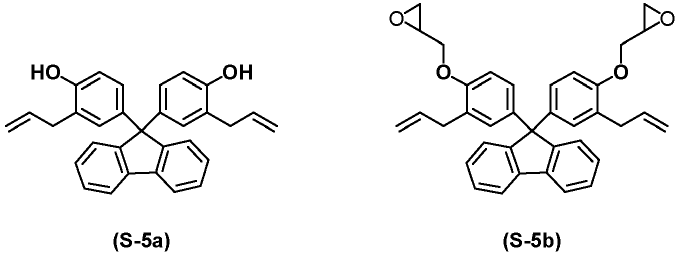

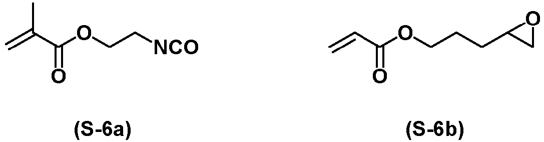

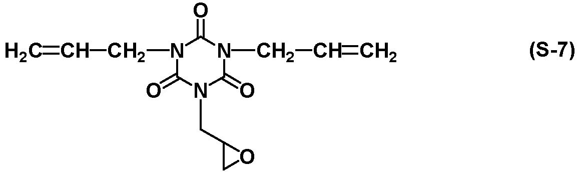

### [1] Synthesis of silicone resin

### Synthesis Example 1

### Synthesis of silicone resin A1

361 g (0.45 mol) of a compound having the formula (S-2a) and 715 g (1.00 mol) of a compound having the formula (S-3a) were added to a 10 L flask equipped with a stirrer, a thermometer, a nitrogen purge line, and a reflux condenser, 1,800 g of toluene was added, and the solution was heated at 70°C. Next, 1.5 g of a chloroplatinic acid toluene solution (platinum concentration: 0.5 wt%) was added, and 105 g (0.54 mol) of a compound having the formula (S-1) was added dropwise over 1 hour (total of hydrosilyl groups : total of alkenyl groups = 0.99 : 1 (molar ratio)). After completion of the dropwise addition, the reaction solution was heated to 100°C and was aged for 7 hours, and then toluene was distilled from the reaction solution under reduced pressure to obtain a silicone resin A1. Mw of the silicone resin A1 was 12,000. It was verified by ¹H-NMR (manufactured by Bruker Corporation) that the silicone resin A1 was a polymer containing the repeat unit having the formula (A1) and the repeat unit having the formula (A2).

### Synthesis Example 2

### Synthesis of silicone resin A2

1,513 g (0.50 mol) of a compound having the formula (S-2b), 606 g (0.85 mol) of a compound having the formula (S-3b), and 28.0 g (0.15 mol) of a compound having the formula (S-4) were added to a 10 L flask equipped with a stirrer, a thermometer, a nitrogen purge line, and a reflux condenser, 3,000 g of toluene was added, and the solution was heated at 80°C. Next, 2.5 g of a chloroplatinic acid toluene solution (platinum concentration: 0.5 wt%) was added, and 95.3 g (0.49 mol) of the compound having the formula (S-1) was added dropwise over 1 hour (total of hydrosilyl groups : total of alkenyl groups = 0.99 : 1 (molar ratio)). After completion of the dropwise addition, the reaction solution was heated to 105°C and was aged for 10 hours, and then toluene was distilled from the reaction solution under reduced pressure to obtain a silicone resin A2. Mw of the silicone resin A2 was 18,000. It was verified by ¹H-NMR (manufactured by Bruker Corporation) that the silicone resin A2 was a polymer containing the repeat unit having the formula (A1), the repeat unit having the formula (A2), the repeat unit having the formula (A3), and the repeat unit having the formula (A4).

### Synthesis Example 3

### Synthesis of silicone resin A3

908 g (0.30 mol) of the compound having the formula (S-2b), 387 g (0.90 mol) of a compound having the formula (S-5a), and 18.6 g (0.10 mol) of the compound having the formula (S-4) were added to a 10 L flask equipped with a stirrer, a thermometer, a nitrogen purge line, and a reflux condenser, 2,100 g of toluene was added, and the solution was heated at 70°C. Next, 1.0 g of a chloroplatinic acid toluene solution (platinum concentration: 0.5 wt%) was added, and 134 g (0.69 mol) of the compound having the formula (S-1) was added dropwise over 1 hour (total of hydrosilyl groups : total of alkenyl groups = 0.99 : 1 (molar ratio)). After completion of the dropwise addition, the reaction solution was heated to 90°C and was aged for 11 hours, and then toluene was distilled from the reaction solution under reduced pressure to obtain a polymer. 2,500 g of propylene glycol monomethyl ether acetate was added to the polymer, and after confirming that propylene glycol monomethyl ether acetate was dissolved, 279 g (1.80 mol) of a compound having the formula (S-6a) and 5.06 g (0.05 mol) of triethylamine were added and the solution was heated at 50°C for 12 hours. After completion of the reaction, propylene glycol monomethyl ether acetate and triethylamine were distilled from the reaction solution under reduced pressure to obtain a silicone resin A3. Mw of the silicone resin A3 was 14,000. It was verified by ¹H-NMR (manufactured by Bruker Corporation) that the silicone resin A3 was a polymer containing the repeat unit having the formula (A1), the repeat unit having the formula (A2), the repeat unit having the formula (A3), and the repeat unit having the formula (A4).

### Synthesis Example 4

### Synthesis of silicone resin A4

401 g (0.50 mol) of the compound having the formula (S-2a) and 431 g (1.00 mol) of the compound having the formula (S-5a) were added to a 10 L flask equipped with a stirrer, a thermometer, a nitrogen purge line, and a reflux condenser, 1,900 g of toluene was added, and the solution was heated at 80°C. Next, 1.4 g of a chloroplatinic acid toluene solution (platinum concentration: 0.5 wt%) was added, and 95.3 g (0.49 mol) of the compound having the formula (S-1) was added dropwise over 1 hour (total of hydrosilyl groups : total of alkenyl groups = 0.99 : 1 (molar ratio)). After completion of the dropwise addition, the reaction solution was heated to 100°C and was aged for 12 hours, and then toluene was distilled off from the reaction solution under reduced pressure to obtain a polymer. 1,800 g of propylene glycol monomethyl ether acetate was added to the polymer, and after confirming that propylene glycol monomethyl ether acetate was dissolved, 312 g (2.00 mol) of a compound having the formula (S-6b) and 10.1 g (0.10 mol) of triethylamine were added and the solution was heated at 70°C for 10 hours. After completion of the reaction, propylene glycol monomethyl ether acetate and triethylamine were distilled from the reaction solution under reduced pressure to obtain a silicone resin A4. Mw of the silicone resin A4 was 13,000. It was verified by ¹H-NMR (manufactured by Bruker Corporation) that the silicone resin A4 was a polymer containing the repeat unit having the formula (A1), the repeat unit having the formula (A2), the repeat unit having the formula (A3), and the repeat unit having the formula (A4).

### Synthesis Example 5

### Synthesis of silicone resin A5

321 g (0.40 mol) of the compound having the formula (S-2a), 499 g (0.92 mol) of a compound having the formula (S-5b), and 14.9 g (0.08 mol) of the compound having the formula (S-4) were added to a 10 L flask equipped with a stirrer, a thermometer, a nitrogen purge line, and a reflux condenser, 700 g of toluene was added, and the solution was heated at 90°C. Next, 1.3 g of a chloroplatinic acid toluene solution (platinum concentration: 0.5 wt%) was added, and 115 g (0.59 mol) of the compound having the formula (S-1) was added dropwise over 1 hour (total of hydrosilyl groups : total of alkenyl groups = 0.99 : 1 (molar ratio)). After completion of the dropwise addition, the reaction solution was heated to 100°C and was aged for 6 hours, and then toluene was distilled from the reaction solution under reduced pressure to obtain a polymer. 1,000 g of propylene glycol monomethyl ether acetate was added to the polymer, and after confirming that propylene glycol monomethyl ether acetate was dissolved, 475 g (5.52 mol) of methacrylic acid and 24.1 g (0.092 mol) of triphenylphosphine were added, and the solution was heated at 110°C for 12 hours. After completion of the reaction, propylene glycol monomethyl ether acetate and methacrylic acid were distilled from the reaction solution under reduced pressure to obtain a silicone resin A5. Mw of the silicone resin A5 was 15,000. It was verified by ¹H-NMR (manufactured by Bruker Corporation) that the silicone resin A5 was a polymer containing the repeat unit having the formula (A1), the repeat unit having the formula (A2), the repeat unit having the formula (A3), and the repeat unit having the formula (A4).

### Comparative Synthesis Example 1

### Synthesis of comparative silicone resin A'1

215.0 g (0.5 mol) of the compound having the formula (S-5a) was added to a 3 L flask equipped with a stirrer, a thermometer, a nitrogen purge line, and a reflux condenser, 2,000 g of toluene was added, and the solution was heated at 70°C. Next, 1.0 g of a chloroplatinic acid toluene solution (platinum concentration: 0.5 wt%) was added, and 67.9 g (0.35 mol) of the compound having the formula (S-1) and 453.0 g (0.15 mol) of the compound having the formula (S-2b) were added dropwise over 1 hour (total of hydrosilyl groups/total of alkenyl groups = 1/1 (molar ratio)). After completion of the dropwise addition, the reaction solution was heated to 100°C and was aged for 6 hours, and then toluene was distilled from the reaction solution under reduced pressure to obtain a comparative silicone resin A'1. Mw of the comparative silicone resin A'1 was 62,000.

### Comparative Synthesis Example 2

### Synthesis of comparative silicone resin A'2

53.00 g (0.20 mol) of a compound having the formula (S-7) and 162.6 g (0.30 mol) of the compound having the formula (S-5b) were added to a 3 L flask equipped with a stirrer, a thermometer, a nitrogen purge line, and a reflux condenser, 2,000 g of toluene was added, and the solution was heated at 70°C. Next, 1.0 g of a chloroplatinic acid toluene solution (platinum concentration: 0.5 wt%) was added, and 48.5 g (0.25 mol) of the compound having the formula (S-1) and 755.0 g (0.25 mol) of the compound having the formula (S-2b) were added dropwise over 1 hour (total of hydrosilyl groups/total of alkenyl groups = 1/1 (molar ratio)). After completion of the dropwise addition, the reaction solution was heated to 100°C and was aged for 6 hours, and then toluene was distilled from the reaction solution under reduced pressure to obtain a comparative silicone resin A'2. Mw of the comparative silicone resin A'2 was 83,000.

### Comparative Synthesis Example 3

### Synthesis of comparative silicone resin A'3

27.9 g (0.15 mol) of the compound having the formula (S-4), 27.1 g (0.05 mol) of the compound having the formula (S-5b), and 129.0 g (0.30 mol) of the compound having the formula (S-5a) were added to a 3 L flask equipped with a stirrer, a thermometer, a nitrogen purge line, and a reflux condenser, 2,000 g of toluene was added, and the solution was heated at 70°C. Next, 1.0 g of a chloroplatinic acid toluene solution (platinum concentration: 0.5 wt%) was added, and 87.3 g (0.45 mol) of the compound having the formula (S-1) and 79.3 g (0.05 mol) of the compound having the formula (S-2a) were added dropwise over 1 hour (total of hydrosilyl groups/total of alkenyl groups = 1/1 (molar ratio)). After completion of the dropwise addition, the reaction solution was heated to 100°C and was aged for 6 hours, and then toluene was distilled from the reaction solution under reduced pressure to obtain a comparative silicone resin A'3. Mw of the comparative silicone resin A'3 was 24,000.

### [2] Preparation of photosensitive resin composition

### Examples 1 to 14 and Comparative Examples 1 to 12

The components were compounded according to the compounding amounts shown in Tables 1 and 2, were stirred and dissolved at an ordinary temperature, and were precisely filtered through a 1.0 µm filter manufactured by TEFLON^{®} to prepare photosensitive resin compositions according to Examples 1 to 14 and Comparative Examples 1 to 12.

**Table 1**

| Component (pbw) | | | Example | | | | | | | | | | | | | |
|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 |
| (A) | Silicone resin | A1 | 100 | - | - | - | - | 100 | - | - | - | - | 50 | - | - | - |
| | | A2 | - | 100 | - | - | - | - | 100 | - | - | - | 50 | 50 | - | - |
| | | A3 | - | - | 100 | - | - | - | - | 100 | - | - | - | 50 | 50 | - |
| | | A4 | - | - | - | 100 | - | - | - | - | 100 | - | - | - | 50 | 50 |
| | | A5 | - | - | - | - | 100 | - | - | - | - | 100 | - | - | - | 50 |
| (B) | Photoradical generator | B1 | 3 | - | - | - | 8 | - | - | 3 | - | 1 | - | - | 5 | - |
| | | B2 | - | 3 | - | - | - | 8 | - | 3 | 3 | 1 | - | - | - | 5 |
| | | B3 | - | - | 5 | - | - | - | 3 | - | 3 | 1 | 3 | - | - | - |
| | | B4 | - | - | - | 5 | - | - | 3 | - | - | 1 | - | 3 | - | - |
| (C) | Crosslinker | C1 | - | - | - | - | - | 5 | - | 30 | - | - | - | 25 | 10 | - |
| | | C2 | - | - | - | - | - | - | 5 | - | 30 | - | - | 25 | - | 10 |
| (D) | Silane coupling agent | D1 | - | - | - | - | - | - | - | - | - | 1 | - | 4 | - | 5 |
| | | D2 | - | - | - | - | - | - | - | - | - | - | 1 | - | 4 | 5 |
| (E) | Solvent | Cyclopentanone | 55 | 55 | 55 | 55 | 55 | 55 | 55 | 55 | 55 | 55 | 55 | 55 | 55 | 55 |

**Table 2**

| Component (pbw) | | Comparative Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Comparative silicone resin | A'1 | 100 | 100 | 100 | 100 | - | - | - | - | - | - | - | - |
| | A'2 | - | - | - | - | 100 | 100 | 100 | 100 | - | - | - | - |
| | A'3 | - | - | - | - | - | - | - | - | 100 | 100 | 100 | 100 |
| Photoacid generator | B'1 | 1 | - | 3 | - | 5 | - | 8 | - | 1 | 1 | 1 | 1 |
| | B'2 | - | 1 | - | 3 | - | 5 | - | 8 | 1 | 1 | 1 | 1 |
| Crosslinker | C'1 | 5 | 10 | 30 | 25 | - | - | - | - | 5 | - | 25 | - |
| | C'2 | - | - | - | 25 | 30 | - | - | - | - | 30 | 25 | - |
| Silane coupling agent | D1 | - | - | 5 | - | - | 4 | - | - | - | 5 | 4 | - |
| | D2 | - | 3 | - | - | - | - | - | - | - | 5 | - | - |
| Solvent | Cyclopentanone | 55 | 55 | 55 | 55 | 55 | 55 | 55 | 55 | 55 | 55 | 55 | 55 |
| Benzotriazole | F1 | - | 0.1 | 0.3 | 0.5 | - | - | - | 1 | - | - | 0.3 | - |

In Tables 1 and 2, B1 to B4, B'1, and B'2 are as shown below.

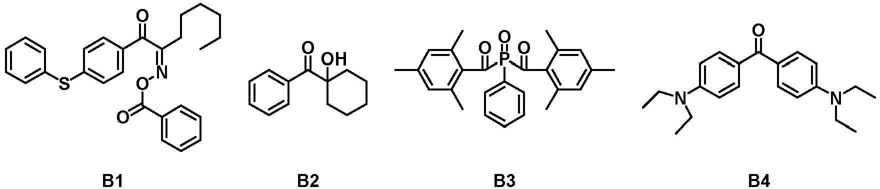

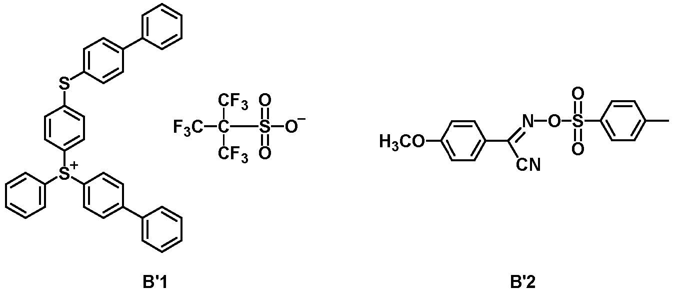

In Tables 1 and 2, C1, C2, C'1, and C'2 are as shown below.

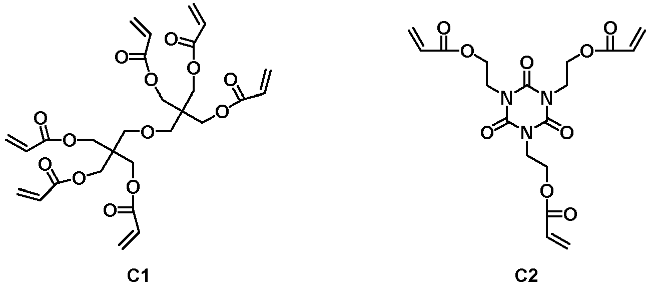

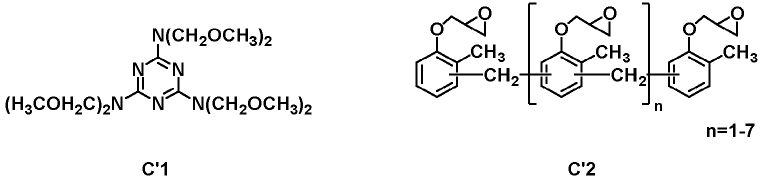

In Tables 1 and 2, D1 is "KBM-503" (trade name, 3-methacryloxypropyltrimethoxysilane, manufactured by Shin-Etsu Chemical Co., Ltd.), and D2 is "KBM-403" (trade name, 3-glycidoxypropyltrimethoxysilane, manufactured by Shin-Etsu Chemical Co., Ltd.).

### [3] Evaluation of resin coating

### (1) Pattern formation and evaluation

A substrate for a migration test (conductive material is copper, interval between conductive parts and width of conductive part are 20 µm, thickness of conductive part is comb-shaped electrode substrate of 4 µm) was coated with each of the photosensitive resin compositions at a thickness of 20 µm using a spin coater. In order to remove the solvent from the composition, the substrate was heated and dried at 100°C for 5 minutes using a hot plate to obtain a photosensitive resin coating. The obtained photosensitive resin coating was irradiated with light having a wavelength of 365 nm at an exposure amount of 500 mJ/cm² through a quartz mask including combinations of fixed-width lines and spaces in a line width range of 1 µm to 50 µm. The exposure was performed using a stepper exposure device NSR-1755i7A (manufactured by Nikon Corporation). Next, spray development was performed on the exposed photosensitive resin coating using PGMEA for 180 seconds to form a pattern. Here, in Comparative Examples 1 to 12, the entire exposed region was developed, and thus the post-exposure baking process (PEB) was performed. Likewise, the development was performed by performing the PEB step under optimized conditions of 140°C and 5 minutes. Finally, the photosensitive resin coating on the substrate on which the pattern was formed was post-cured using an oven while performing nitrogen purge at 120°C for 2 hours, and the photosensitive resin coating was observed. By observing a pattern cross-section with a SEM, the resolved minimum pattern size was set as maximum resolution. From the obtained cross-sectional photo, perpendicularity was evaluated. A perpendicular pattern was evaluated as "⊚", a pattern where a tapered shape or footing was slightly observed was evaluated as "O", and a pattern where a tapered shape or footing was strongly observed was evaluated as "△", and opening failure was evaluated as "×".

### (2) Evaluation of electrical characteristics (copper migration)

The substrate on which the pattern was formed using the method (1) was used as a substrate for copper migration evaluation to perform a test. The copper migration test was performed under conditions of a temperature of 130°C, a humidity of 85%, and an applied voltage of 15 V to check the time at which short-circuit occurred with the upper limit of 1,000 hours.

### (3) Evaluation of electrical characteristics (breakdown strength)

In order to evaluate the breakdown strength of the photosensitive resin coating obtained from the photosensitive resin composition, a steel sheet having a size of 13 cm × 15 cm and a thickness of 0.7 mm was coated with each of the photosensitive resin compositions shown in Tables 1 and 2 using a bar coater, was exposed using a contact aligner exposure device under an exposure condition of a wavelength of 405 nm without a mask, and was heated using an oven at 100°C for 2 hours to obtain a photosensitive resin coating. The photosensitive resin composition was coated such that the thickness of the obtained coating was 0.2 µm. The photosensitive resin coating was tested using a breakdown tester TM-5031AM (manufactured by Tamadensoku Co., Ltd.), a voltage was applied at a voltage increase rate of 5 V/sec, and a voltage at which the test specimen was broken was measured and set as the breakdown strength of the coating.

### (4) Evaluation of solvent resistance

In order to evaluate solvent resistance to N-methyl-2-pyrrolidone (NMP) widely used for forming a semiconductor device or the like, using each of the photosensitive resin compositions shown in Tables 1 and 2, a 15 mm × 15 mm pattern was formed on a silicon wafer using the same method as that of the preparation of the wafer for the copper migration test of (1), and was post-cured while performing nitrogen purge at 110°C for 2 hours. After dipping the wafer in NMP at 40°C for 1 hour, a change in thickness and external appearance were inspected to evaluate the solvent resistance. A case where there was no change in the external appearance and the thickness was evaluated as "○", and a case where swelling, a decrease in thickness, or the like was observed was evaluated as "×".

The results are shown in Tables 3 and 4.

**Table 3**

| | Example | | | | | | | | | | | | | |
|---|---|---|---|---|---|---|---|---|---|---|---|---|---|---|
| | 1 | 2 | 3 | 4 | 5 | 6 | 7 | 8 | 9 | 10 | 11 | 12 | 13 | 14 |
| Maximum resolution (µm) | 10 | 10 | 10 | 10 | 10 | 15 | 15 | 15 | 15 | 10 | 10 | 10 | 10 | 10 |
| Pattern shape | ○ | ○ | ○ | ○ | ○ | ⊚ | ⊚ | ⊚ | ⊚ | ⊚ | ⊚ | ⊚ | ⊚ | ⊚ |
| Copper migration test 1,000 hr (short-circuit duration hr) | No short-circuit | | | | | | | | | | | | | |
| Solvent resistance | ○ | ○ | ○ | ○ | ○ | ○ | ○ | ○ | ○ | ○ | ○ | ○ | ○ | ○ |
| Electrical characteristics breakdown strength (V/µm) | 500 | 510 | 505 | 510 | 500 | 530 | 535 | 530 | 540 | 555 | 560 | 565 | 560 | 555 |

**Table 4**

| | Comparative Example | | | | | | | | | | | |
|---|---|---|---|---|---|---|---|---|---|---|---|---|
| | 1 | 2 | 3 | 4 | 5 | 6 | 7 | 8 | 9 | 10 | 11 | 12 |
| Maximum resolution (µm) | 50 | 50 | 50 | 50 | 50 | 50 | 50 | 50 | 50 | 50 | 50 | 50 |
| Pattern shape | Δ | Δ | Δ | Δ | Δ | Δ | Δ | Δ | Δ | Δ | Δ | Δ |
| Copper migration test 1,000 hr (short-circuit duration hr) | 100 | 200 | 100 | 200 | 100 | 100 | 200 | 200 | 200 | 100 | 200 | 100 |
| Solvent resistance | × | × | × | × | × | × | × | × | × | × | × | × |
| Electrical characteristics breakdown strength (V/µm) | 320 | 315 | 330 | 340 | 325 | 305 | 335 | 340 | 345 | 320 | 315 | 320 |

In the above results, in the photosensitive resin composition according to the invention, unlike the photosensitive resin composition in the prior art including a silicone resin containing an epoxy group or a phenol group at a side chain and a photoacid generator, a fine size pattern was able to be formed, and a cured film having high chemical resistance or copper migration resistance was able to be formed even when cold-cured at 150°C or lower. In addition, since the cured film has the above-described characteristics, the photosensitive resin composition can be suitably used as a coating forming material for protection of various electrical or electronic parts such as circuit boards, semiconductor devices, or display devices.

## Claims

1. A photosensitive resin composition comprising:
(A) a silicone resin that has a silphenylene structure, a polysiloxane structure, and a fluorene structure at a main chain and has an acryloyl group or a methacryloyl group at a side chain; and
(B) a photoradical generator.

2. The photosensitive resin composition according to claim 1, wherein (A) the silicone resin is a polymer which contains a repeat unit having the formula (A1) and a repeat unit having the formula (A2) and may further contain at least one type selected from a repeat unit having the formula (A3) and a repeat unit having the formula (A4): 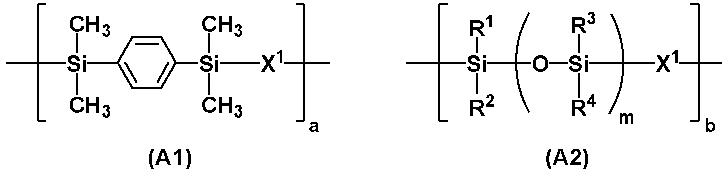 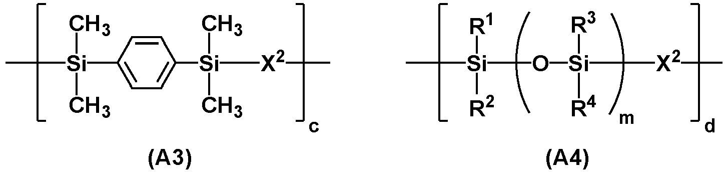
wherein R¹ to R⁴ are each independently a C₁-C₂₀ hydrocarbyl group which may contain a heteroatom, m are each independently an integer of 1 to 600, groups R³ may be the same or different and groups R⁴ may be the same or different when m is an integer of at least 2, a, b, c, and d are numbers in the range: 0 < a < 1, 0 < b < 1, 0 ≤ c < 1, 0 ≤ d < 1, and a+b+c+d = 1, X¹ is a divalent group having the formula (X1), and X² is a divalent group having the formula (X2), 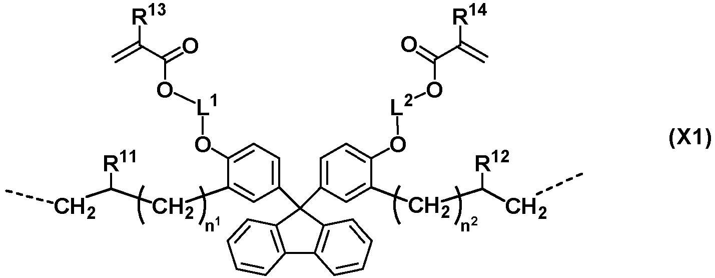
wherein R¹¹ to R¹⁴ are each independently a hydrogen atom or a methyl group, n¹ and n² are each independently an integer of 1 to 7, L¹ and L² are each independently a C₁-C₁₅ saturated hydrocarbylene group, some of -CH₂- in the saturated hydrocarbylene group may be substituted by -O-, -S-, -SO₂-, -CO-, -CONH-, some or all of hydrogen atoms in the saturated hydrocarbylene group may be substituted by a hydroxy group, and a broken line is a valence bond, and 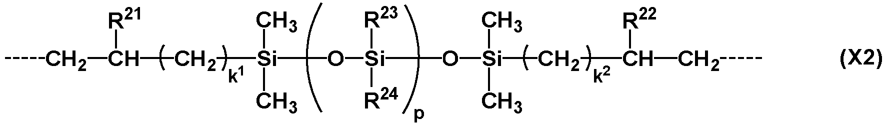
wherein R²¹ and R²² are each independently a hydrogen atom or a methyl group, R²³ and R²⁴ are each independently a C₁-C₈ hydrocarbyl group, k¹ and k² are each independently an integer of 0 to 7, p is an integer of 0 to 600, and a broken line is a valence bond.

3. The photosensitive resin composition according to claim 1, further comprising (C) a crosslinker containing two or more (meth)acryloyl groups.

4. The photosensitive resin composition according to claim 1, further comprising (D) a silane coupling agent.

5. The photosensitive resin composition according to claim 1, further comprising (E) a solvent.

6. A pattern forming process comprising the steps of:
(i) forming a photosensitive resin coating on a substrate using the photosensitive resin composition according to any one of claims 1 to 5;
(ii) exposing the photosensitive resin coating to radiation; and
(iii) developing the exposed photosensitive resin coating in a nonaqueous developer and dissolving an unexposed region to form a pattern.

7. The pattern forming process according to claim 6, further comprising (iv) a step of post-curing, at a temperature of 40 to 150°C, the photosensitive resin coating on which the pattern is formed by development.

8. The photosensitive resin composition according to any one of claims 1 to 5, which is a material of a coating for protection of electrical or electronic parts.
